# EUROPEAN PATENT SPECIFICATION

(11) **EP 0 298 718 B1**
(45) Date of publication and mention of the grant of the patent: **16.03.1994**
(21) Application number: 88306153.3
(22) Date of filing: 06.07.1988
(51) Int. Cl.: H01H 47/32

(54) **Relay circuit having a pulse generator for closing contacts**
Relaisschaltanordnung mit einem Impulsgenerator zum Schliessen der Kontakte
Circuit de relais ayant un générateur d'impulsion pour la fermeture des contacts

(30) Priority: 07.07.1987 JP 170169/87
(43) Date of publication of application: 11.01.1989
(73) Proprietor: NEC CORPORATION, Tokyo (JP)
(72) Inventor: Tamura, Yoshiharu, Minato-ku Tokyo (JP)
(74) Representative: Orchard, Oliver John

(56) References cited:
- DE-A- 3 504 034
- FR-A- 2 568 715
- GB-A- 2 150 790
- GB-A- 2 181 311

## Description

### BACKGROUND OF THE INVENTION

The present invention relates to a relay circuit.

With conventional electromagnetic or solid-state relays, a DC voltage of a given polarity is applied only once to the relay when operating it. With latching relays, a voltage of opposite polarity is applied to the relay when releasing it. If the relay fails to respond to a rapidly rising edge of the applied voltage for any reason, it is incapable of recovering from the failure and its contacts remain open or closed indefinitely. The same holds true if the relay, once operated, accidentally opens its contacts due to impact from an external source. Such accidental open contacts tend to occur frequently with the latching relays. A prior art attempt to avoid this problem involves the use of a resistor-capacitor circuit which is connected between the relay winding and a DC voltage source through a switch to absorb oscillatory currents generated by the vibratory movements, or "chattering", of the contacts of the switch when it is closed.

In the specification of UK Patent Application No. 8408175, which was published under number 2150790 on July 3 1985, there was proposed an automatic telephone hold-releasing circuit for a plurality of telephones which included means for detecting a voltage drop occurring in a talking-circuit section upon the off-hook operation of a telephone set other than that with which a call had been initially answered, and means for comparing the voltage drop with a holding voltage, a relay being energised to close its contacts during holding and deenergised to break the contacts in response to the voltage drop, thereby automatically releasing the holding state of the initially answered telephone set.

A feature of a relay circuit to be described is that a contact failure is detected either when a rapidly rising voltage is first applied, or when the relay is already energized and the same voltage is reapplied.

Elements of a relay circuit to be described below include a relay having a stationary contact adapted to be coupled to a DC voltage source and a moving contact adapted to be coupled to a load circuit for switching the moving contact to the stationary contact in response to a rapidly rising edge of a DC voltage applied to the relay. A voltage sensor is connected to the moving contact of the relay for detecting a voltage which appears thereat. For operating the relay, a switch is closed to apply a voltage from the DC voltage source to a pulse generator. The pulse generator applies a rectangular pulse to the relay when a voltage is not detected by the voltage sensor in the presence of a voltage applied through the switch. If the voltage is not detected by the voltage sensor at the moving contact after energization of the relay, the pulse generator reapplies a rectangular pulse to the relay until a voltage appears at the moving contact. When a voltage is detected at the moving contact by the voltage sensor, the pulse generator applies a constant voltage to the relay.

In a practical aspect, the pulse generator includes a capacitor coupled through the switch to the voltage source. The pulse generator discharges the capacitor at periodic intervals to generate one or more rectangular pulses. The voltage sensor includes a circuit that establishes a short circuit across the capacitor to terminate its charging and discharging action when the voltage appears at the moving contact of the relay. A series circuit of a resistor and a diode is connected to the switch to apply current to the capacitor and a breakdown diode is coupled to the moving contact of the relay to detect a voltage thereat. A transistor is provided having a base connected to the breakdown diode and a collector connected to a junction between the resistor and diode to establish the short circuit across the capacitor when a current is supplied from the breakdown diode.

An embodiment of the invention will now be described, by way of example, with reference to the accompanying drawings, in which:
Fig. 1 is a circuit diagram of a relay circuit of the present invention;
Fig. 2 is a diagram illustrating waveforms that appear in Fig. 1 when the relay is recovered after accidental open contacts; and
Fig. 3 is a diagram illustrating waveforms that appear in Fig. 1 when the relay is recovered when the battery is recharged after an accidental or excessive current drain.

### DETAILED DESCRIPTION

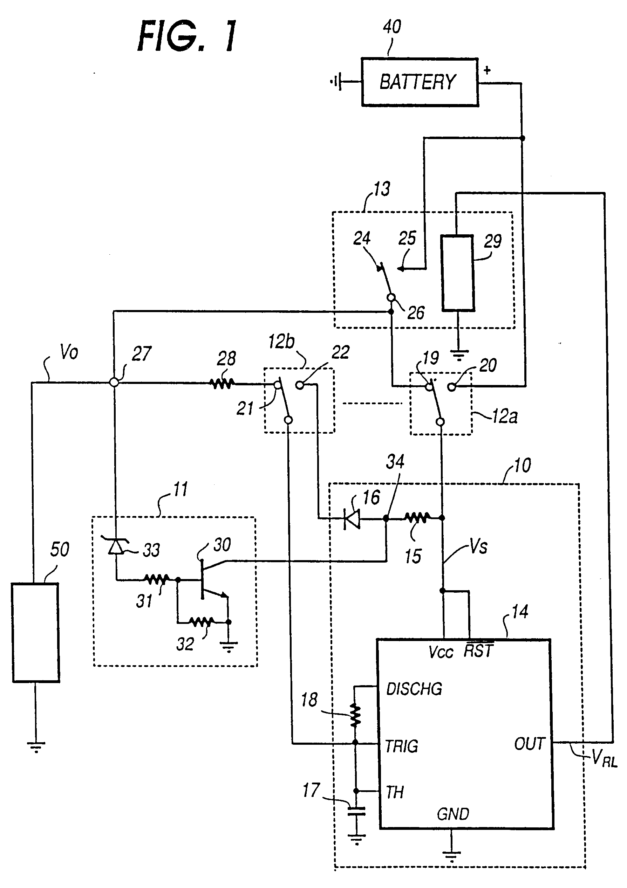

Referring now to Fig. 1, there is shown a relay circuit of the present invention. The relay circuit generally comprises a pulse generator 10, a voltage sensing and oscillator disabling circuit 11, a pair of manually operated switches 12a, 12b, and an integrated circuit relay 13. Relay 13 has a moving contact 26 normally switched to an OFF position contact 24 and switched to an ON position contact 25 when operated to supply a positive potential from a battery 40 to an output terminal 27 to which a load circuit 50 is connected.

Pulse generator 10 comprises an integrated circuit oscillator 14, and a series circuit including a resistor 15 and a diode 16 whose cathode is connected to an ON position contact 22 of switch 12b. Diode 16 is poled to conduct current from the positive terminal of a battery 40 to charge a capacitor 17 when a voltage is not appearing at the moving contact 26. Capacitor 17 is coupled to the trigger input port of the integrated circuit 14 and is discharged through a resistor 18 to a discharge input port of the IC oscillator 14. The trigger input port of the oscillator 14 is connected to the moving contact of switch 12b. Switch 12a has an OFF position contact 19 coupled to the moving contact 26 of the relay and an ON position contact 20 coupled to the positive terminal of battery 40. Switch 12b has an OFF position contact 21 connected through a resistor 28 to the output terminal 27. The IC oscillator 14 has a voltage supply input port Vcc and a reset input port RST which are coupled together to one end of the resistor 15 and to the moving contact of switch 12a. The reset port R̅S̅T̅ is constantly supplied with a high voltage and responsive to a reset signal of low voltage to clear the IC oscillator 145. The output port of oscillator 14 is connected to the contact operating circuit 29.

Voltage sensing and oscillator disabling circuit 11 is formed by a switching transistor 30, resistors 31, 32 and a Zener diode 33. Transistor 30 has its collector connected to a junction 34 between resistor 15 and diode 16, with the emitter being connected to ground. The base of transistor 30, which is coupled to the anode of Zener diode 33 by resistor 31, is biased by a potential developed across resistor 32 when the breakdown diode 33 is conducting. The cathode of Zener diode 33 is connected to the moving contact 26 of the relay 13 to detect a voltage thereat.

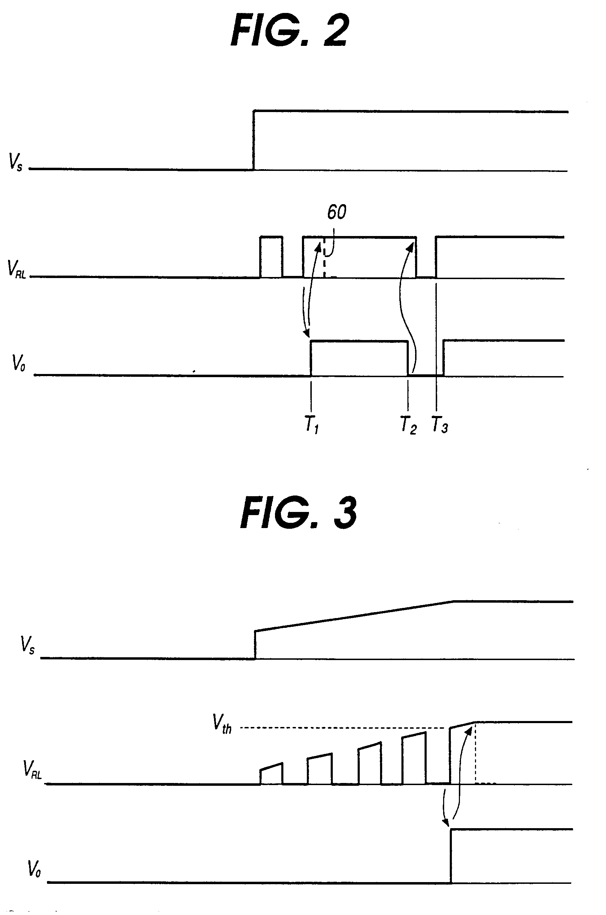

When the relay 13 is not energized, the output terminal 27 is at zero voltage level and hence the Zener diode 33 is off and transistor 30 remains in an off state. Under this condition, the oscillator 14 is enabled. Operation of switches 12a and 12b from their OFF positions to ON positions causes a battery voltage Vs (see Fig. 2) to appear at the Vcc and reset ports of the IC oscillator 14 and a current to flow through resistor 15, diode 16 and switch 12b to the trigger input of oscillator 14, charging the capacitor 17 to develop a voltage at the trigger input. When the voltage at the trigger input port reaches a specified level, the oscillator 14 causes the capacitor 17 to be discharged through resistor 18 and charged again with the current from the battery. The process is repeated so that capacitor 17 is charged and discharged at periodic intervals. Thus, the output voltage V_{RL} of oscillator 14 oscillates between high and low voltage levels and drives the contact operating circuit 29 of the IC relay 13. Moving contact 26 of the relay is switched to the ON position contact 25 in response to a rapid voltage rise at the second rising edge of voltage V_{RL} at the time T₁, for example, due to inherent delay. The positive potential of battery 40 is therefore applied through the relay contact to the output terminal 27, supplying a voltage Vₒ to the load circuit 50. The application of voltage Vₒ at the output terminal 27 causes a current to flow through the Zener diode 33 and resistors 31 and 32 to ground, biasing the transistor 30 into a conductive state. Thus, the junction 34 between resistor 15 and diode 16 is driven to zero voltage level, terminating the charging current to the capacitor 17. As a result, the oscillating mode of oscillator 14 is disabled and its output voltage V_{RL} is stabilised at a high level. The moving conact 26 thus remains switched to the ON position contact 25, continuously supplying the output voltage Vₒ to the load circuit 50. If the moving contact 26 fails to respond to the second rising edge of the relay drive pulse, the charging operation will be continued and the oscillator output voltage V_{RL} will fall again to the low voltage level, producing a second pulse as indicated by a dotted line 60 in Fig. 2. The oscillator will produce a third pulse to allow the relay 13 to respond to it.

Assume that the relay moving contact 26 switches to the OFF position contact 24 in response to an impact or the like at time T₂, the potential at the output terminal 27 falls to zero level and the Zener diode 33 and hence the transistor 30 is turned off, allowing the potential at the junction 34 to rise to a high level to resume the capacitor charging and discharging operation. Oscillator 14 is therefore triggered again to oscillate its output voltage V_{RL}, producing a rapid voltage rise at time T₃. If the energy produced by the oscillator 14 at this moment is sufficient to switch the moving contact 26 to the ON position contact 25, transistor 30 is again turned on to cease the charging of capacitor 17. Otherwise, the charge and discharge operation of capacitor 17 is repeated to oscillate the voltage V_{RL} until the contact operating circuit 29 is supplied with sufficient energy to drive the contact 26.

Assume that the battery 40 has been accidentally or excessively drained during operation and the contact operating circuit 29 loses sufficient energy to keep the moving contact 26 switched to the ON position contact 25. If the battery 40 is recharged later voltage Vₛ gradually increases as shown in Fig. 3 and causes a current to flow through resistor 15 and diode 16 to capacitor 17 to reinitiate the oscillation of the output voltage V_{RL.} When the amplitude of the oscillation rises to a sufficient level Vₜₕ for the relay 13, the moving contact 26 is switched again to the ON position contact 25 because of the impact energy produced by the rapid voltage rise and a voltage Vo will appear again at the output terminal 27.

It is seen therefore that the relay 13 is arranged to automatically receive impulses in repetition until its contacts are switched. Because of the high energy level of the impulse, the inherent inertia of the relay 13 can be easily overcome and the period of undesirable open conditions of the relay can be reduced to a minimum.

The foregoing description shows only one preferred embodiment of the present invention. Various modifications are apparent to those skilled in the art without departing from the scope of the present invention which is only limited by the appended claims. Therefore, the embodiment shown and described is only illustrative, not restrictive.

## Claims

1. A relay circuit including a relay (13) having a first contact (25) and a second contact (26), the second contact (26) being connected to a load circuit (50), first voltage sensing means (33) connected to the second contact (26) for detecting a voltage thereat, and a switch (12a) connected to a DC voltage source (40) for energizing the relay (13), characterised in that the load circuit (50) is supplied with current from the DC voltage source (40) through the first and second contacts (25, 26) when the relay (13) is energised, and in that a pulse generator (10) is energized by a voltage supplied through the switch (12a) for energizing the relay (13) with a rectangular driving pulse if no voltage is detected at the second contact (26) by the voltage sensing means (33), and for energizing the relay (13) with a constant voltage if a voltage is detected at the second contact (26) by the voltage sensing means (33).

2. A relay circuit as claimed in claim 1, characterised in that the pulse generator (10) continuously produces the driving pulse at periodic intervals as long as no voltage is detected at the second contact (26) by the voltage sensing means (33).

## Patentansprüche

1. Relais-Schaltungsanordnung mit einem Relais (13), das einen ersten Kontakt (25) und einen zweiten Kontakt (26) aufweist, wobei der zweite Kontakt (26) an einen Verbraucherschaltkreis (50) angeschlossen ist, einer ersten Spannungsfühleinrichtung (33), die zur Erfassung einer Spannung am zweiten Kontakt (26) angeschlossen ist, und einem Schalter (12a), der zur Anregung des Relais (13) an eine Gleichstromspannungsquelle (40) angeschlossen ist, dadurch gekennzeichnet, daß der Verbraucherschaltkreis (50) durch den ersten und zweiten Kontakt (25, 26) mit Strom von der Gleichstromspannungsquelle (40) versorgt wird, wenn das Relais (13) angeregt ist, und daß ein Impulsgenerator (10) von einer über den Schalter (12a) zugeleiteten Spannung angeregt wird, um das Relais (13) mit einem Rechteck-Treiberimpuls anzuregen, wenn am zweiten Kontakt (26) keine Spannung von der Spannungsfühleinrichtung (33) erfaßt wird, und um das Relais (13) mit einer konstanten Spannung anzuregen, wenn am zweiten Kontakt (26) eine Spannung von der Spannungsfühleinrichtung (33) erfaßt wird.

2. Relais-Schaltungsanordnung nach Anspruch 1, dadurch gekennzeichnet, daß der Impulsgenerator (10) so lange andauernd den Treiberimpuls in periodischen Intervallen erzeugt wie am zweiten Kontakt (26) keine Spannung von der Spannungsfühleinrichtung (33) erfaßt wird.

## Revendications

1. Circuit de relais comportant un relais (13) ayant un premier contact (25) et un second contact (26), le second contact (26) étant connecté à un circuit de charge (50), un premier moyen sensible à la tension (33) connecté au second contact (26) afin de détecter une tension sur celui-ci, et un commutateur (12a) connecté à une source de tension continue (40) afin d'alimenter le relais (13), caractérisé en ce que le circuit de charge (50) reçoit du courant à partir de la source de tension continue (40) par l'intermédiaire des premier et second contacts (25, 26) lorsque le relais (13) est alimenté, et en ce qu'un générateur d'impulsions (10) est alimenté par une tension délivrée par l'intermédiaire du commutateur (12a) afin d'alimenter le relais (13) avec une impulsion de commande rectangulaire dans le cas d'absence de tension détectée au niveau du second contact (26) par le moyen sensible à la tension (33), et pour alimenter le relais (13) avec une tension constante dans le cas où une présence de tension est détectée au niveau du second contact (26) par le moyen sensible à la tension (33).

2. Circuit de relais selon la revendication 1, caractérisé en ce que le générateur d'impulsions (10) produit de manière continue l'impulsion de commande à des intervalles périodiques tant que l'absence de tension est détectée au second contact (26) par le moyen sensible à la tension (33).
